Europäisches Patentamt

European Patent Office

Office européen des brevets

(19)

(11) EP 1 450 406 A1

(12) **EUROPEAN PATENT APPLICATION**

(43) Date of publication:
**25.08.2004 Bulletin 2004/35**

(51) Int Cl.⁷: **H01L 23/525**

(21) Application number: **03251007.5**

(22) Date of filing: **19.02.2003**

(84) Designated Contracting States:
**AT BE BG CH CY CZ DE DK EE ES FI FR GB GR
HU IE IT LI LU MC NL PT SE SI SK TR**
Designated Extension States:
**AL LT LV MK RO**

(71) Applicant: **CAVENDISH KINETICS LIMITED
Nr Royston, Hertfordshire SG8 8PZ (GB)**

(72) Inventors:
  • **van Kampen, Robert
  5237 - PL, 's Hertogenbosch (NL)**

  • **Smith, Charles Gordon
  Cambridge - CB4 1hg (GB)**
  • **Kazinski, Robert
  5213 - AE, 'S Hertogenbosch (NL)**

(74) Representative: **Haley, Stephen
  Gill Jennings & Every,
  Broadgate House,
  7 Eldon Street
  London EC2M 7LH (GB)**

(54) **Micro fuse**

(57)     A micro fuse for use in a semiconductor device. The micro fuse comprises an insulating substrate and an elongate metal fuse member, the fuse member being supported at either end on the substrate and including at least one fuse region suspended out of contact with the substrate and shaped such that, in use, a predetermined current can be applied to it to make it non-conducting.

At least one barrier may be formed between the fuse region of the fuse member and the insulator.

The fuse member may be formed from a readily oxidisable metal, such as Titanium, Tungsten, Tantalum, Copper or Aluminium.

The fuse member may have two or more fuse regions, with a region between adjacent fuse regions being supported by a metal track. In this case, the fuse member may also be supported on the substrate via one or more inter layers.

EP 1 450 406 A1

**Description**

The present invention relates to a micro fuse, in particular a MEMS micro fuse, for use in semiconductor devices.

During the fabrication of semiconductor microprocessors and memory chips there is a need for one-time programmable non-volatile structures that are used to record which active devices on the chip have failed. The chips are designed to have spare devices which can be switched in to replace the failed devices. This built-in redundancy allows a higher chip yield per wafer. After test onboard non-volatile memory devices are used to record which devices have failed and which ones are being used to replace them.

There are various non-volatile devices employed at the moment to record this data. These structures are sometimes referred to as repair fuse boxes. In some fabrication facilities the information is stored in electronically programmable semiconductor devices such as EEPROM's and FLASH memory devices. These non-volatile devices need different semiconductor processes than that used to provide the random access memory (DRAM) or microprocessor devices on the rest of the chip, so are expensive to add. Instead of these active devices, often cheaper metal lines are used which can be blown using a focussed laser beam or a large current density applied along their length. The laser technique can only be performed in the fabrication facility after test. It is a slow process involving test, followed by laser cutting in a separate tool, followed by test. The test identifies the failed elements and the fuses are blown to bring in new devices. After this the surface has to be passivated with a layer to prevent ions and water vapour causing damage to the chips during dicing and packaging of the wafer.

The fuses which are blown using high current densities are hard to produce because the surrounding metal has to cover a large area to accommodate the large currents. This makes the cell size for these structures large. When the metal does blow it can redeposit on the insulator that the metal track sits on. Generally for metal tracks on a substrate, the threshold for destroying the wires is controlled by the current density and is variable, depending on the detailed grain structure, and resistivity of the metal.

Other techniques employ an anti-fuse which consists of a very thin insulator placed between two metals. When a large electric field is placed across the insulator, it breaks down creating a shorted path. The problem with this technology is that the shorted path can vary greatly in resistance from device to device. This is because the breakdown will be initiated at regions of high electric field which depend on the surface roughness.

The object of this patent is to provide one time programmable fusible link which can be electrically programmed, is faster to programme, has less collateral damage and can be produced with a higher yield.

According to the present invention there is provided a micro fuse for use in a semiconductor device, the micro fuse comprising:

an insulating substrate: and

an elongate metal fuse member, the fuse member being supported at either end on the substrate and including at least one fuse region suspended out of contact with the substrate and shaped such that, in use, a predetermined current can be applied to it to make it non-conducting.

At least one barrier may be formed between the fuse region of the fuse member and the insulator.

The fuse member may be formed from a readily oxidisable metal, such as Titanium, Tungsten, Tantalum, Copper or Aluminium.

The fuse member may have two or more fuse regions, with a region between adjacent fuse regions being supported by a metal track. In this case, the fuse member may also be supported on the substrate via one or more inter layers. Corresponding methods of manufacture of the fuse are also provided.

The invention involves fabricating a double-clamped cantilever structure which does not touch the substrate along its length. Because the wire does not touch the substrate the heat loss is via thermal conduction along the wire length, rather than out through the substrate. The heat going in is related to the resistance in the free standing wire. The heat which leaves is also related to the resistance of the wire via the Wiedemann-Franz law, that relates the thermal conductivity to the electrical resistivity. The heat loss from the lattice vibrations or Phonons is small in comparison to that lost by the conduction of the electrons. For micron sized or sub-micron sized wires, the heat loss from radiation is small. If we consider the scaling laws for the various heat loss mechanisms and compare this with the heat dumped into the wire of radius r and length L and resistivity R due to electronic heating by a current I, then:

for a small element dx the heat going in is given by $I^2R$, or $I^2 \, pdx/ \pi r^2$

The heat loss from the ends of the wire is dominated by the thermal conductivity $K_e$ of the electrons and so is proportional to the area of the wire $\pi r^2$ and the thermal gradient along the wire.

The heat lost due to radiation which goes as the surface area $2\pi r.dx.s_B T^4$, where $s_B$ is Stephan's constant. The heat input is $\dfrac{I^2\rho}{\pi r^2 R}$ and the radiation is $\dfrac{2s_B T^4}{r}$

The balance equation is then:

$$\frac{\partial}{\partial x}\left(\pi r^2 k\,\frac{\partial T}{\partial x}\right) + \frac{I^2 R\rho}{\pi r^2} - 2\pi s_B T^4 r = 0$$

Given that for metals at room temperature $K_e$ is related to the resistivity by the Wiedemann Franz law:

$K_e = LT/\rho$, where L is the Lorenz constant ($L = (\pi^2/3)(k_B/e)^2$). $K_B$ is the Boltzmann constant and e is the charge of an electron. We also need to calculate the above differential equation is a functional form for the temperature dependence of the resistivity.

Considering scaling of such a formula, assume that all fuse dimensions (radius, length) are reduced by a scaling factor F. For a given temperature change dT in the fuse, we can see that the heat lost via thermal conduction does not change with the scaling factor, but the heat lost via thermal radiation is reduced by a factor F. Thus, as the fuse dimensions are scaled down, the heat lost via radiation will become negligible compared to the heat lost via thermal conduction. Ignoring the radiation term in the balance equation, we can see that if all dimensions of the fuse are reduced by a factor F, then the current required to melt the fuse is reduced by a factor F as well.

Because of the simple thermal properties, the fuses can be designed to predictably fuse at a well defined voltage dropped along its length. This also results in a well defined temperature dependence along the wire length, with the central portion being the hottest, this results in better control of the temperature at the centre of the wire. A consequence of this is that a very small region can be melted in a controllable fashion at the centre of the free standing double clamped cantilever. Because the melted region is small, there is a lower probability that the evaporated metal will short out the fused wire, or that the melted material will land somewhere else on the chip and cause damage. When the central part of the double cantilever has been melted away the two end parts remain free standing. This means that the broken fuse does not touch the surrounding insulator, which may have some evaporated metal on the surfaces. This helps in maintaining a well defined difference between the on and off resistance.

The threshold for blowing the device is given by the voltage dropped along the wire which is a product of the wire dimensions and the wire resistivity. As these values are well controlled the voltage for switching can be well predicted. To read the state of the wire, the current through the wire can be measured with a device to limit the voltage drop across the fuse. To blow the wire the current limiting device can be removed, which results in a voltage being dropped across the wire that is greater than the threshold for melting. Because the wire is not connected to the substrate along its length it has a very small specific heat which allows it to reach melting temperatures in a very short time.

To ensure that no evaporated metal from the fuse causes a continuous conducting path between the two blown ends of the wire, there may be provided a barrier between the melted portion and at least one end of the blown fuse where it touches the substrate.

The present invention, with its free-standing fuse member, has benefits in terms of its ability to be positioned about other active devices without causing damage to them when fusing. We have shown that when the fuse member blows at over 3,000K the temperature under the centre of the fuse member does not raise by more than 60K. Furthermore, the fuse members are smaller than prior art arrangements, and therefore requires lower currents to fuse, resulting in less damage to adjacent components, reducing the spacing. This in turn helps reduce routing problems and timing problems that occur with prior art fuses that, by their nature, needs to be located some way away from other memory areas. The low current fusing requirements also mean that the fuses do not need an extra power pad, reducing further the component count in a device employing the fuse.

Examples of the present invention will now be described with reference to the accompanying drawings, in which:

Figures 1 to 3 show a first example microfuse according to the invention, including a method of manufacture thereof;
Figures 4 and 5 show a second example microfuse according to the invention during manufacture and after being blown;
Figures 6 to 8 show a further example of the present invention both during manufacture, prior to and after being blown; and
Figure 9 shows a further example of the present invention employing an oxidizing metal.
Figure 10 shows another example of the present invention employing an in-plane design.
Figures 11a-f show a micro fuse according to the present invention at the various stages of its fabrication.

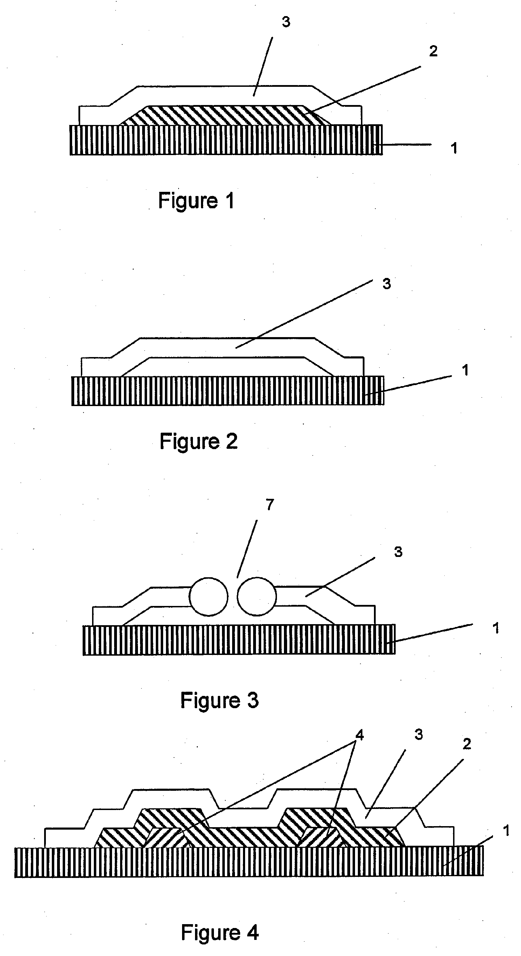

Figure 1 shows a technique for fabricating an example MEMS micro fuse of the present invention. A substrate 1 is provided which may be an insulator on top of a silicon chip containing completed semiconductor devices, such as memory products or microcontrollers. A sacrificial layer 2 is provided a substrate and which can be removed using a gas plasma etch without removing other layers, such as substrate 1, appreciably during release. A metal conducting layer 3 is provided. This layer 3 is normally formed from the metal used in one of the metalisation layers of the underlying semiconductor devices in orderto minimise manufacturing complexity. This layer 3 can be formed Aluminium, Aluminium Copper, Copper, Titanium Nitride, or Titanium, or Tungsten or Tantalum or Tantalum Nitride, for example. The sacrificial layer 2 can be Silicon Nitride, sputtered amorphous silicon, or a different material which etches selectively compared to the metal of the fuse layer 3.

Figure 2 shows a diagram of the fuse after the sacrificial layer 2 has been etched.

As can be seen from figure 2, a central fuse region 7 is provided suspended above the insulated substrate 1 and supported at either end from the substrate 1. As discussed above, the centre region 7 has dimensions which can be controlled to a high degree of accuracy, given the manufacturing techniques that are employed, such that the central fusing region can be destroyed by application of an appropriate control current in an extremely reliable and predictable way.

Figure 3 shows the fused wire after the appropriate electric field has been applied. From this it can be seen that the remainder of the layer 3 does not contact substrate 1.

Figure 4 shows a second example MEMS micro fuse according to the invention where an extra layer 4 has been added. This layer 4 can be an insulator or conductor. It is not removed when the sacrificial layer 3 is removed. It provides a line-of-sight barrier for any evaporated metal generated when layer 3 is fused, preventing it forming a continuous path from one end of the layer 3 to the other.

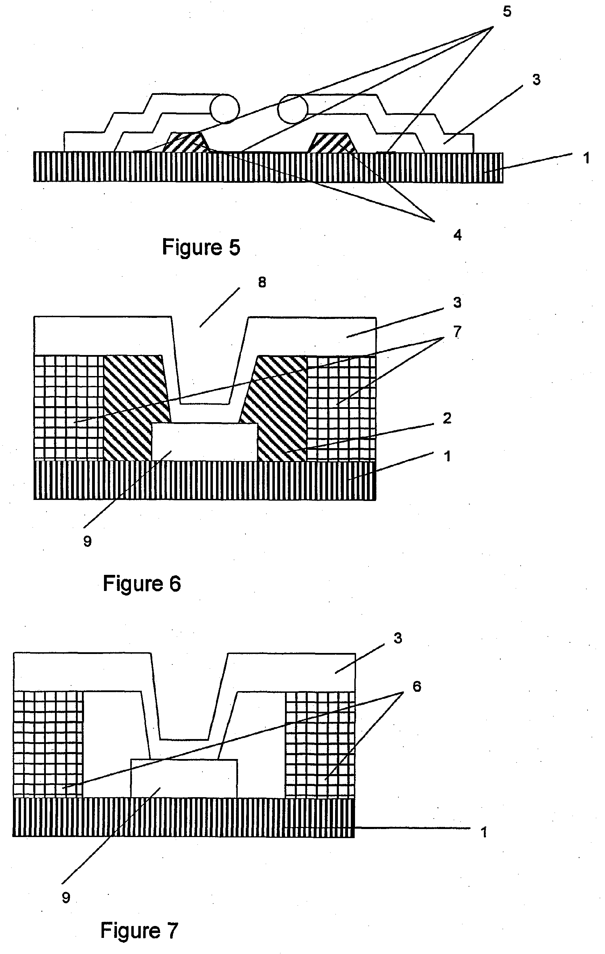

Figure 5 shows the device in figure 4 after the removal of the sacrificial layer during the etch and the subsequent blowing of the fuse region 7. It can be seen that the layer 4 acts as a barrier to break up the evaporated material 5 on the substrate which is generated during blowing of the fuse, and which prevents it shorting out the blown fuse.

It can be seen that, in this example, the sacrificial layer 3 has given the fuse a shape that means that even if layer 4 was removed with layer 5 the fuse shape is such that the region of the fuse close to the base acts as a barrier to prevent the metal evaporated at the region 7 of the metal layer 3 reaching the substrate 1, and this configuration may be employed in the invention.

In both the above examples it is possible to chose the fuse metal in layer 3 such that when it is heated so that it fuses the evaporated metal is chosen to be very reactive, so that it oxidizes as it evaporates. Metals such as Al, Ta, Ti, TiN or Cu would all oxidize if evaporated in air. This means that the residue after the fuse is blown becomes an insulator and so will not cause any problems with shorting.

Another example of the invention, shown in figures 6 to 8, has a vertical fuse portion to reduce the area it occupies on the chip. The fuse of this example can replace the standard via technology which connects metal tracks at different levels in the chip. The fabrication of such a vertical arrangement will now be described. In this construction layer 6 is a inter metal dielectric on the substrate 1. A hole 8 is opened in the interlayer dielectric 6 above track 9 which runs into the view shown. A sacrificial layer 2 is then put into the hole 8 and a polish is performed back to the dielectric layer 6. A small via hole is then opened up down through the sacrificial layer 2 to metal track layer 9. Then a metal layer 3 is deposited into the hole 8. The side wall coverage is reduced due to shadowing effects.

Figure 7 shows the structure of figure 6 after the sacrificial layer 2 has been removed.

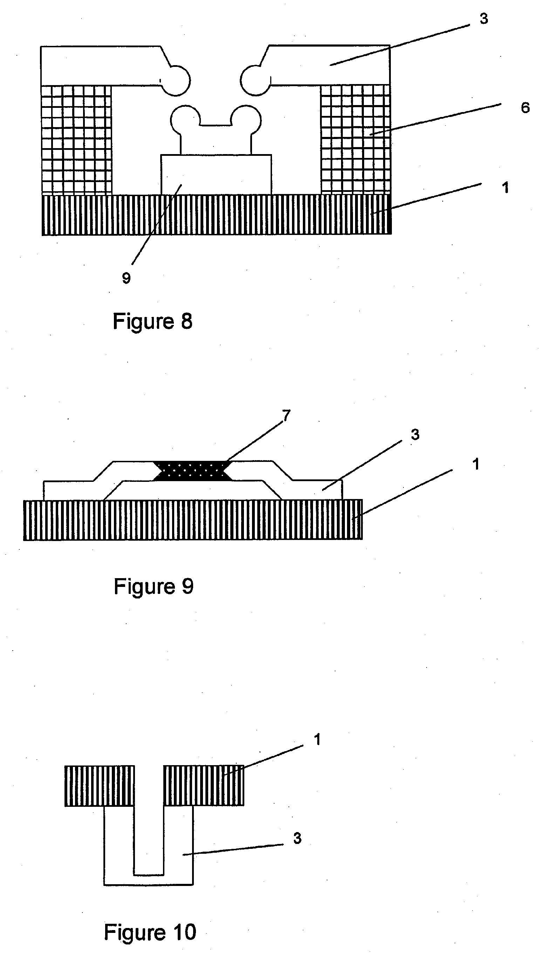

Figure 8 shows the vertical fuse of figure 7 after melting. If, instead of the etched hole, an etched groove running along metal track 9 is produced, then track 9 can provide two fuses, one from each side. In this case, they can be separately blown by applying a potential difference between track 9 and the left hand side of layer 3, while keeping the right hand side of layer 3 at the same voltage as track 9.

In order to get continuous coverage of metal up the side of the etched sacrificial layer 2, it is important that the side wall is not undercut or vertical. Alternatively Plasma enhanced CVD may be used with a metal such as TiN on the side walls of hole 8 before deposition of the top metal layer 3. This technique gives better conformal coverage of vertical side walls.

In a fourth example, it is possible to make the fuse out of a metal layer 3 which oxidizes at high temperatures. The metal may be Ti, Ta, W, Cu or Al, for example. Then when a current is passed through the fuse region 7, it is heated up above a threshold temperature for oxidation in air. At elevated temperatures the metal begins to be oxidized. By designing the metal layer 3 to be thin enough, the growth of a surface oxide on the top, bottom and sides is such that there is no longer any conductive material left. The advantage of this technique is that there is no evaporation of material which could provide a short between the two ends of the cantilever.

Figure 9 shows such an example with a fuse region 7 after it has been heated by applying a voltage across the metal length 3 while in air. The hottest portion (in the middle) has reached a temperature above a threshold temperature for oxidation (for example with TiN this is 350° C). This hot region then oxidizes turning the metal into an insulator.

Figure 10 shows an example of the present invention showing an in-plane design. This design has the advantage of eliminating the shorting of the two beam bases. The metal length 3 consists of two parallel beams connected together by a third beam that is considerably narrower than the other two beams. When this fuse blows the narrow connecting beam blows and the configuration of these beams ensures that the evaporated metal cannot extend to the base of the wide beams. This, in turn, ensures that the blown fuse cannot accidentally be short circuited.

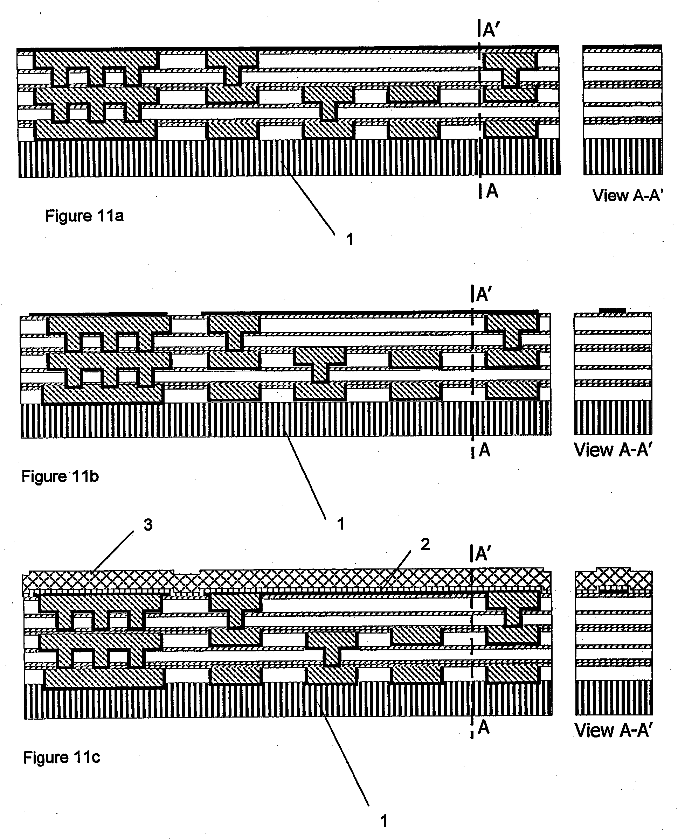

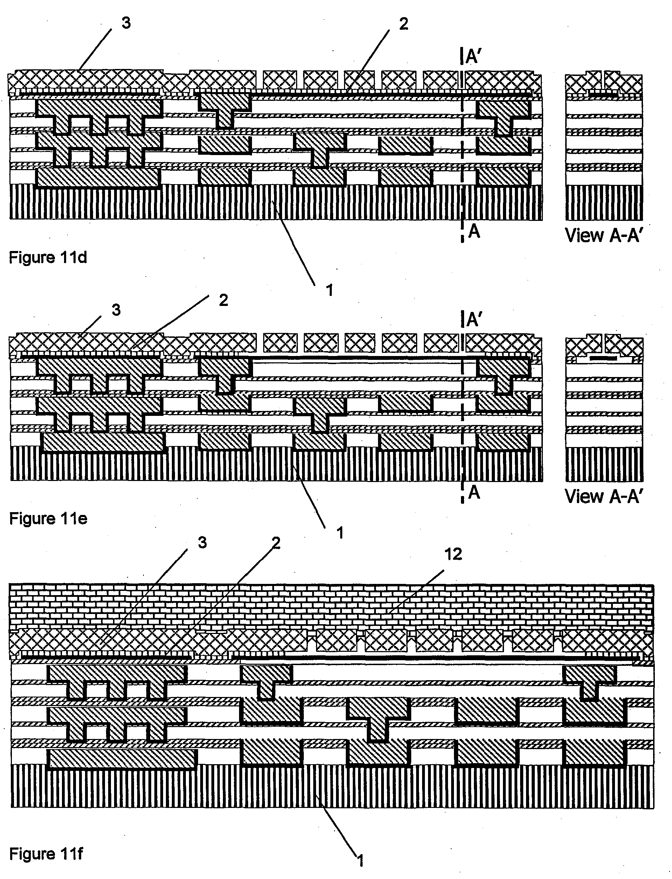

Figures 11a-f show a MEMS micro fuse according to the present invention in the various stages of its fabrication. Figure 11a shows a CMOS wafer that has been processed by a standard dual damascene process up to the last metal layer. This is usually capped with a silicon nitride layer which will be used as the sacrificial layer under the TiN fuse. The thickness of the layer may have to be adjusted to provide a suitable gap under the fuse. During the first masking process a TiN layer is deposited and etched into the desired pattern. The TiN layer that will form the fuse is left over the copper, because it can not be easily etched off the copper with good selectivity. The next stage of the process involves depositing and patterning a SiN sacrificial layer above the fuse, followed by a silicon dioxide layer. A second masking process then takes place to open holes in the oxide layer. This is shown in figure 11d and results in the fuse being ready to be released as shown in Figure 11a. This etch removes the SiN both bellow and above the fuse so that it is only in physical contact to the rest of the chip at each end. Finally a passivation layer is deposited at low pressure to fill up the holes in the silicon dioxide Figure 11f. This etch removes the SiN both below and above the fuse so that it is only in physical contact to the rest of the chip at each end. Finally a passivation layer is deposited at low pressure to fill up the holes in the silicon dioxide Figure 11f. This ensures that the fuses are housed in a controlled atmosphere and at a low pressure. It also ensures that the wafer can be diced and packaged without damage to the free standing fuses. This ensures that when the fuses are blown the heat lost via convection of gas molecules is small in comparison to the heat lost via thermal conduction along the fuse. Finally, the there is a masking stage to open up the bond pads and deposit and pattern A1.

In all of the above examples it is possible to provide a micro fuse for semiconductor devices which can be fused in an extremely reliable fashion due to the highly controlled nature of the manufacture. It is also possible to provide a fuse memberwhich does not contaminate its surrounding environment and hence produces a micro fuse which is more reliable, yet most cost effective, than currently known in micro fuses.

## Claims

1.   A micro fuse for use in a semiconductor device, the micro fuse comprising:

an insulating substrate: and
an elongate metal fuse member, the fuse member being supported at either end on the substrate and including at least one fuse region suspended out of contact with the substrate and shaped such that, in use, a predetermined current can be applied to it to make it non-conducting.

2.   A micro fuse according to claim 1, wherein at least one barrier is formed between the fuse region of the fuse member and the insulator.

3.   A micro fuse according to claim 1 or 2, wherein the fuse member is formed from one or more of the group of Titanium, Tungsten, Tantalum, Copper or Aluminium.

4.   A micro fuse according to any preceding claim, wherein the fuse member may have two or more fuse regions, with a region between adjacent fuse regions being supported by a metal track.

5.   A micro fuse according to claim 4, wherein the fuse member is supported on the substrate via one or more inter layers.

6.   A micro fuse according to any of the preceding claims, wherein said micro fuse is a MEMS micro fuse.

7.   A micro fuse according to any proceeding claim, further comprising an encapsulating layer for encapsulating the region including the fuse member.

8.   A method of manufacturing a micro fuse for use in a semiconductor device, the method comprising the steps of:

applying a shape sacrificial layer to the surface of an insulating substrate;

applying a metal layer to the surface of the insulating substrate and sacrificial layer; and
removing the sacrificial layer, wherein the sacrificial layer is shaped such that, when it is removed, the metal layer is shaped so as to provide a fuse region suspended out of contact with the substrate, the fuse region being shaped so that, in use, a predetermined current can be applied to it to make it non-conductive.

9. A method according to claim 8, and further comprising the step of;
   applying a barrier component to the surface of the substrate such that any evaporated metal generated when the metal layer is fused cannot form a continuous path.

10. A method according to claim 8 or 9, wherein the metal layer provided by physical vapour deposition or chemical vapour deposition.

11. A method according to any of claims 8 to 10, wherein the metal layer is formed from one or more of the group of Titanium, Tungsten, Tantalum, Copper or Aluminium.

12. A method according to any of claims 7 to 10, and further comprising the step of adding an encapsulating layer over the micro fuse.

Figure 1

Figure 2

Figure 3

Figure 4

Figure 5

Figure 6

Figure 7

Figure 8

Figure 9

Figure 10

Figure 11a

View A-A'

1

Figure 11b

View A-A'

1

3

2

Figure 11c

View A-A'

1

Figure 11d

View A-A'

Figure 11e

View A-A'

Figure 11f

**European Patent Office**

**EUROPEAN SEARCH REPORT**

Application Number

EP 03 25 1007

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2002/011645 A1 (BERTIN CLAUDE L ET AL) 31 January 2002 (2002-01-31) * the whole document * | 1-12 | H01L23/525 |
| X | US 4 198 744 A (NICOLAY HUGH C) 22 April 1980 (1980-04-22) * the whole document * | 1,8 | |
| X | US 4 908 692 A (KIKUCHI KOUJI ET AL) 13 March 1990 (1990-03-13) * the whole document * | 1,8 | |
| X | PATENT ABSTRACTS OF JAPAN vol. 1997, no. 07, 31 July 1997 (1997-07-31) & JP 9 069570 A (SEIKO EPSON CORP), 11 March 1997 (1997-03-11) * the whole document * -& JP 09 069570 A (SEIKO EPSON CORP) 11 March 1997 (1997-03-11) | 1,8 | |
| X | DE 196 00 398 C (SIEMENS AG) 27 March 1997 (1997-03-27) * the whole document * | 1,8 | TECHNICAL FIELDS SEARCHED (Int.Cl.7) H01L |
| A | US 6 501 107 B1 (LEVITAN JEREMY A ET AL) 31 December 2002 (2002-12-31) * the whole document * | 6 | |

The present search report has been drawn up for all claims

| Place of search | Date of completion of the search | Examiner |
|---|---|---|
| The Hague | 21 August 2003 | Zeisler, P. |

EPO FORM 1503 03.82 (P04C01)

**ANNEX TO THE EUROPEAN SEARCH REPORT
ON EUROPEAN PATENT APPLICATION NO.**

EP 03 25 1007

This annex lists the patent family members relating to the patent documents cited In the above–mentioned European search report.
The members are as contained in the European Patent Office EDP file on
The European Patent Office Is in no way liable for these particulars which are merely given for the purpose of Information.

21–08–2003

| Patent document cited in search report | | Publication date | Patent family member(s) | | Publication date |
|---|---|---|---|---|---|
| US 2002011645 | A1 | 31–01–2002 | NONE | | |
| US 4198744 | A | 22–04–1980 | US | 4272753 A | 09–06–1981 |
| US 4908692 | A | 13–03–1990 | JP | 1972156 C | 27–09–1995 |
| | | | JP | 6105764 B | 21–12–1994 |
| | | | JP | 63001054 A | 06–01–1988 |
| JP 9069570 | A | 11–03–1997 | NONE | | |
| DE 19600398 | C | 27–03–1997 | DE | 19600398 C1 | 27–03–1997 |
| | | | DE | 19638666 C1 | 20–11–1997 |
| | | | EP | 0783182 A2 | 09–07–1997 |
| | | | JP | 9199603 A | 31–07–1997 |
| | | | US | 6303980 B1 | 16–10–2001 |
| | | | US | 6080649 A | 27–06–2000 |
| US 6501107 | B1 | 31–12–2002 | NONE | | |

EPO FORM P0459

For more details about this annex : see Official Journal of the European Patent Office, No. 12/82